# DEMANDE DE BREVET EUROPEEN

(11) **EP 4 177 967 A1**
(43) Date de publication de la demande: **10.05.2023**
(21) Numéro de dépôt: 22204779.7
(22) Date de dépôt: 31.10.2022
(51) Int. Cl.: H01L 31/0224, H01L 31/18, H01L 31/0468

(54) **CELLULE PHOTOVOLTAÏQUE MUNIE D AU MOINS UNE COUCHE D`OXYDE TRANSPARENT CONDUCTEUR PERFECTIONNEE**

(30) Priorité: 03.11.2021 FR 2111650
(71) Demandeur: Institut Photovoltaïque d'Ile de France - IPVF, 91120 Palaiseau (FR); Electricité de France, 75008 Paris (FR); Centre National de la Recherche Scientifique (CNRS), 75016 Paris (FR); TotalEnergies SE, 92400 Courbevoie (FR); Ecole Polytechnique, 91120 Palaiseau (FR)
(72) Inventeur: JUTTEAU, Sébastien, 91430 IGNY (FR); GRAND, Pierre-Philippe, 83470 SAINT-MAXIMIN-LA SAINTE-BAUME (FR); DUCHATELET, Aurélien, 37190 AZAY-LE-RIDEAU (FR); RAOULT, Emilie, 91300 MASSY (FR)
(74) Mandataire: Plasseraud IP

(57) **Abrégé**

Cellule photovoltaïque (101, 102) comportant au moins une jonction semiconductrice (4) de conversion photo-électrique recouverte sur au moins une de ses faces par au moins une couche transparente conductrice (1, 5) d'extraction de charges électriques de la jonction, pour lequel ladite couche transparente conductrice comporte une alternance de bandes de résistivité supérieure à un premier seuil, dites bandes de résistivité supérieure (11, 11, 53) , et de bandes de résistivité inférieure à un deuxième seuil, dites bandes de résistivité inférieure (2, 3, 7) adaptées pour faciliter un transports desdites charges électriques.

## Description

### Domaine technique

La présente divulgation relève du domaine des cellules photovoltaïques et des méthodes d'amélioration de leur rendement et propose une cellule photovoltaïque munie d'au moins une couche d'oxyde transparent conducteur perfectionnée.

### Technique antérieure

Il est connu de réaliser sur des jonctions semiconductrices photovoltaïques au moins une électrode constituée par une couche de matériau transparent conducteur électrique permettant de transporter les charges électriques issues de la jonction hors de cette jonction tout en laissant passer la lumière vers la jonction.

Cette couche de matériau transparent conducteur est basée sur un compromis entre sa transparence, pour ne pas réduire la lumière reçue par la jonction et sa conductivité qui conditionne l'extraction de courant de la jonction, ces deux grandeurs évoluant de manière opposée.

Dans la recherche de l'accroissement du rendement des cellules photovoltaïques, améliorer la conductivité des couches transparentes conductrices sans réduire leur transparence est un défi.

L'augmentation de la conductivité de telles électrodes réalisées par des couches transparentes conductrices peut être effectuée en ajoutant une grille métallique sur lesdites couches, cette grille étant souvent déposée par pulvérisation cathodique ou sérigraphie à la surface de la couche transparente conductrice. Cette grille métallique ne laisse pas passer le spectre solaire à l'endroit où elle est déposée et limite donc par effet d'ombrage le courant pouvant être collecté par la cellule solaire. Les pertes liées à l'ombrage peuvent être d'ordre de 2 à 5% du courant généré par la cellule solaire. De plus, le métal le plus fréquemment utilisé pour réaliser une telle grille est l'argent, métal onéreux pouvant devenir critique d'ici quelques années.

Une autre solution technique est d'améliorer les propriétés de conduction/transparence de la couche transparente conductrice. Pour une couche transparente conductrice de type oxyde transparent conducteur (TCO) Les oxydes transparents conducteurs les plus fréquemment utilisés sont :
SnO2:F ou FTO pour Dioxyde d'étain dopé Fluor (Fluorine-doped tin oxide en anglais) ;
ITO pour Oxyde d'Indium dopé Etain (Indium tin Oxide en anglais) ;
ZnO pour Oxyde de Zinc, parfois dopé à l'Aluminium (Zinc oxide en anglais).

Les matériaux FTO, ITO et/ou ZnO sont les matériaux qui présentent le meilleur compromis transparence/conductivité à un coût acceptable d'un point de vue industriel. D'autres matériaux, comme l'oxyde de zinc dopé à l'indium IZO (indium zinc oxide en anglais), l'oxyde d'indium hydrogéné IO:H (hydrogenated indium oxide en anglais), l'oxyde d'indium dopé zirconium In₂O₃:Zr (zirconium doped indium oxide en anglais) sont des candidats pour améliorer les propriétés opto-électroniques de ces couches mais l'Indium est un métal cher qui à terme va poser des problèmes de durabilité si le photovoltaïque ainsi que les autres industries qui utilisent ce métal se développent selon les prévisions, la ressource mondiale pouvant devenir inférieure à la demande.

Il est donc souhaitable de limiter l'épaisseur et la surface des couches d'oxyde transparent conducteur sans trop réduire leur conductivité électrique.

Dans ce cadre, le document EP 2 506 312 A1 décrit une cellule pourvue d'une couche TCO pourvue de bandes de résistivité inférieure constituées par un accroissement localisé d'une épaisseur d'un matériau transparent conducteur de ladite couche transparente conductrice.

Le document US 2009/084438 A1 décrit pour sa part d'empiler des couches TCO d'une cellule pour améliorer la conduction.

### Résumé

Au vu de cet art antérieur, la présente divulgation propose une cellule photovoltaïque comportant au moins une jonction semiconductrice de conversion photo-électrique recouverte sur au moins une de ses faces par au moins une couche transparente conductrice d'extraction de charges électriques de la jonction, pour laquelle ladite couche transparente conductrice comporte une alternance de bandes de résistivité supérieure à un premier seuil, dites bandes de résistivité supérieure, et de bandes de résistivité inférieure à un deuxième seuil, dites bandes de résistivité inférieure adaptées pour faciliter un transports desdites charges électriques, pour laquelle ladite couche transparente conductrice est une couche d'oxyde transparent conducteur, ledit oxyde transparent conducteur est un oxyde d'indium dopé étain (ITO), un oxyde d'indium dopé zinc (IZO) ou un oxyde d'aluminium dopé zinc (AZO) et pour laquelle lesdites bandes de résistivité inférieure comportent un surdopage localisé de ladite couche d'oxyde transparent conducteur avec un dopant conducteur par rapport aux bandes de résistivité supérieure sans accroissement d'épaisseur desdites bandes de résistivité inférieure.

Selon cette réalisation, les bandes de résistivité inférieure surdopées bien que de transparence réduite permettent de réduire l'épaisseur totale de la couche et donc d'en accroître la transparence pour améliorer le compromis conductivité/transparence de la couche.

Les caractéristiques exposées dans les paragraphes suivants peuvent, optionnellement, être mises en œuvre, indépendamment les unes des autres ou en combinaison les unes avec les autres :

Préférablement, la cellule photovoltaïque comporte au moins une jonction semiconductrice de conversion photo-électrique recouverte sur au moins une de ses faces par au moins une couche transparente conductrice d'extraction de charges électriques de la jonction, ladite couche transparente conductrice comportant une alternance de bandes de résistivité supérieure à un premier seuil, dites bandes de résistivité supérieure, et de bandes de résistivité inférieure à un deuxième seuil, dites bandes de résistivité inférieure adaptées pour faciliter un transports desdites charges électriques.

Avantageusement, ledit deuxième seuil est inférieur ou égal audit premier seuil. Des seuils de 20 Ohm/carré à 30 Ohm/carré pour les bandes de résistivité réduite et de 40 Ohm/carré à 50 Ohm/carré pour les bandes de résistivité supérieure sont par exemple des limites acceptables.

Dans le cas d'une couche transparente conductrice réalisée à partir d'un matériau de type oxyde transparent conducteur, le dopant peut être du même type que le dopant dudit matériau.

Avantageusement, lesdites bandes de résistivité inférieure peuvent occuper une surface de 5 à 20% de la surface totale de ladite couche transparente conductrice. Ceci permet d'adapter le ratio transparence/conductivité en fonction du type de cellule.

Selon un mode de réalisation particulier, les bandes de résistivité inférieure sont orientées dans une direction de transport du courant de ladite cellule vers une cellule adjacente. Les bandes peuvent aussi être orientées perpendiculairement à ladite direction, des lignes de liaison métalliques transversales auxdites bandes collectant le courant généré dans les cellules.

La présente divulgation concerne en outre un procédé de réalisation d'un module photovoltaïque à une ou plusieurs cellules.

Selon un premier mode de réalisation, le procédé comporte :
a. le dépôt d'une première couche primaire de matériau transparent conducteur sur un substrat tel qu'une lame de verre par pulvérisation cathodique et un surdopage localisé de bandes de ladite première couche primaire avec un dopant conducteur par un procédé choisi parmi la diffusion, l'implantation ionique, le dopage in situ avec masque pendant une croissance épitaxiale de ladite première couche primaire, le transport vapeur-liquide-solide (VLS) pour réaliser une première couche transparente conductrice à bandes alternées de résistivité inférieure et de résistivité supérieure,
b. une gravure de ladite première couche transparente conductrice à bandes alternées de résistivité inférieure et de résistivité supérieure pour former des premières électrodes de liaison entre lesdites cellules ;
c. un dépôt d'une ou plusieurs couches de jonction photovoltaïque sur lesdites premières électrodes de liaison ;
d. une gravure de ladite une ou plusieurs couches de jonction photovoltaïque pour former les jonctions desdites cellules sur lesdites premières électrodes ;
e. le dépôt d'au moins une deuxième couche primaire transparente conductrice ou d'une couche en matériau conducteur opaque sur lesdites jonctions et une gravure de ladite deuxième couche pour réaliser des deuxièmes électrodes de liaison entre cellules.

Le procédé peut comporter, avant la gravure de ladite deuxième couche primaire, un surdopage localisé de bandes de la deuxième couche primaire par un procédé choisi parmi la diffusion, l'implantation ionique, le dopage in situ avec masque pendant une croissance épitaxiale de ladite deuxième couche primaire, le transport vapeur-liquide-solide (VLS) pour réaliser des bandes alternées de résistivité inférieure et de résistivité supérieure.

Selon un deuxième mode de réalisation, le procédé comporte :
la fabrication d'une première jonction photovoltaïque sans électrodes supérieure et inférieure ;
a. un dépôt par pulvérisation cathodique d'au moins une couche transparente conductrice supérieure sur une face supérieure de ladite cellule et d'au moins une couche transparente conductrice inférieure sur une face inférieure de ladite cellule ;
b. un surdopage localisé de premières bandes parallèles transparentes conductrices sans accroissement d'épaisseur, sur une face externe d'au moins une desdites couche transparente conductrice inférieure et couche transparente conductrice supérieure par pulvérisation cathodique, en utilisant un masque.

Pour effectuer un raccordement avec une autre cellule ou l'extérieur d'un module, le procédé peut comporter un dépôt d'une grille métallique par pulvérisation cathodique au travers d'un masque, perpendiculairement auxdites bandes parallèles transparentes conductrices sur au moins ladite face externe d'au moins une desdites couche transparente conductrice supérieure et couche transparente conductrice inférieure.

Pour la réalisation d'une cellule photovoltaïque tandem le procédé peut comporter:
a. un dépôt d'une deuxième jonction photovoltaïque sur une face avant formée par la première couche transparente conductrice;
b. un dépôt d'une troisième couche transparente conductrice par pulvérisation cathodique sur une face libre de ladite deuxième jonction photovoltaïque ;
c. un surdopage localisé de deuxièmes bandes parallèles transparentes conductrices sans accroissement localisé sur ladite troisième couche ;
d. un dépôt d'une deuxième grille métallique par pulvérisation cathodique, perpendiculaire aux bandes transparentes conductrices d'épaisseur accrue sur ladite troisième couche.

Les couches transparentes conductrices sont préférablement des couches d'oxyde transparent conducteur.

### Brève description des dessins

D'autres caractéristiques, détails et avantages apparaîtront à la lecture de la description détaillée ci-après, et à l'analyse des dessins annexés, sur lesquels :
[Fig. 1] est une vue schématique d'une couche d'oxyde transparent conducteur avec bandes avec accroissement localisé d'épaisseur ;
[Fig. 2] est une vue schématique d'une couche d'oxyde transparent conducteur avec bandes avec accroissement localisé de dopage ;
[Fig. 3] est une vue schématique coupe de cellules photovoltaïque munies de couches d'oxyde transparent conducteur pourvues de bandes selon deux modes de réalisation de la présente divulgation;
[Fig. 4] est une vue de dessus d'une couche d'oxyde transparent conducteur avec selon un mode de réalisation avec ajout de grille métallique ;
[Fig. 5] est un graphique distance/résistance ;
[Fig. 6] est un graphique longueur d'onde/transmission ;
[FIG. 7A], [FIG. 7B], [FIG. 7C], [FIG. 7D], FIG. 7E], [FIG. 7F], [FIG. 7G] représentent des étapes de réalisation de cellules selon un premier exemple ;
[FIG. 8A], [FIG. 8B], [FIG. 8C], [FIG. 8D] représentent des étapes de réalisation de cellules selon un deuxième exemple.
FIG. 9A], [FIG. 9B], [FIG. 9C], [FIG. 9D] représentent des étapes de réalisation d'une cellule selon un troisième exemple.

### Description des modes de réalisation

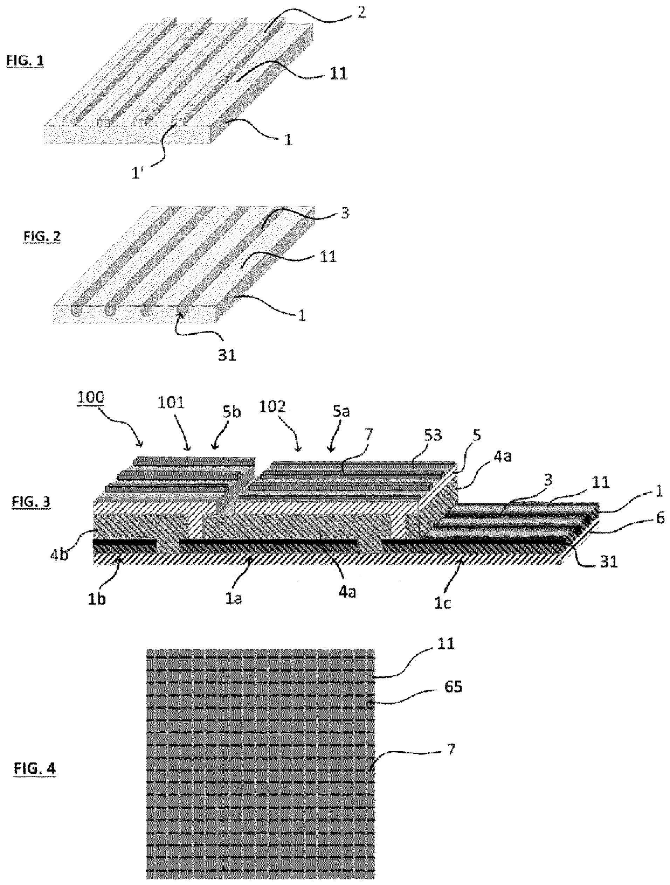

La présente divulgation propose d'améliorer les propriétés optoélectroniques d'une couche transparente conductrice pour cellule photovoltaïque et notamment d'une couche transparente conductrice à base d'oxyde transparent conducteur, ci-après TCO pour (transparent conductive oxyde en anglais) de réalisation d'une électrode de collecte des charges électriques générées par une jonction photovoltaïque. La présente divulgation traite en particulier de l'optimisation de la conductivité de la couche tout en limitant fortement les pertes de transmission optiques de cette couche. Pour ce faire la présente divulgation propose de modifier localement les propriétés de la couche transparente conductrice par une diminution de sa résistivité selon des bandes de résistivité réduite par rapport à la résistivité de la couche en dehors desdites bandes de résistivité réduite. Deux modes de réalisation sont prévus, l'un consistant, selon le principe de la figure 1, à réaliser une couche de faible épaisseur pour une transparence importante et à augmenter localement l'épaisseur de la couche selon des bandes dont l'augmentation d'épaisseur réduit la résistivité de cette couche, l'autre consistant, selon le principe de la figure 2, à réaliser une couche de faible épaisseur et à réaliser un accroissement local du taux de dopants conducteurs dans cette couche selon des bandes de résistivité réduite.

L'épaisseur des couches TCO traditionnelles est de l'ordre de 100 nanomètres à 400 nanomètres et leur résistivité de l'ordre de 10 Ohm/carré à 30 Ohm/carré selon le type de cellule solaire. L'Ohm/carré est l'unité de résistance électrique pour les couches minces (résistance par carré) dimensionnellement égale à l'Ohm.

La figure 1 correspond à un premier mode de réalisation comportant une couche TCO 1 d'une épaisseur réduite par rapport à l'épaisseur traditionnelle des couches d'oxyde transparent conducteur, et comportant des bandes d'épaisseur accrue 2 du matériau TCO qui vont diminuer localement la résistivité de ce matériau.

Le matériau TCO peut être choisi notamment parmi:
SnO2:F ou FTO Fluorine-doped tinoxide (Dioxyde d'étain dopé Fluor)
ITO ou Indium tin Oxide (Oxyde d'Indium dopé Etain)
ZnO ou Zinc oxide (Oxyde de Zinc, parfois dopé à l'Aluminium)

La couche TCO complète selon le mode de réalisation de la figure 1 comporte ainsi une alternance :
a. - de bandes de faible épaisseur, par exemple de l'ordre de 40 nanomètres à 60 nanomètres de bonne transparence mais de résistivité supérieure à un premier seuil, par exemple d'environ 40 Ohm/carré à 50 Ohm/carré voire 60 Ohm/carré et qui sont les bandes de la couche de base dites bandes de résistivité supérieure 11, et,
b. - de bandes d'épaisseur accrue, par exemple d'épaisseur comprise entre 200 nanomètres et 500 nanomètres et de résistivité inférieure à un deuxième seuil, par exemple d'au plus 30 Ohm/carré et préférablement inférieur à 20 Ohm/carré, dites bandes de résistivité inférieure 2 et adaptées pour faciliter un transport desdites charges électriques.

Le premier seuil, qui peut aussi être la résistance en Ohm/carré d'une couche TCO traditionnelle d'épaisseur de l'ordre de 100 nanomètres est supérieur ou égal au deuxième seuil.

Les bandes de résistivité inférieure 2 sont réalisées au moyen d'un accroissement localisé 1' de la couche d'oxyde transparent conducteur constitué par le dépôt d'une couche secondaire TCO déposée par exemple par un procédé de pulvérisation cathodique sur une couche TCO de base. La couche TCO de base réalise pour sa part les bandes de résistivité supérieure 11.

Un exemple de réalisation fabriquée en laboratoire utilise l'IZO pour réaliser une électrode à couche transparente conductrice comportant une couche de base de 47 nm avec une résistivité de 90 Ohm/carré et des bandes d'épaisseur accrue d'épaisseur totale 307 nm avec une résistivité de 11 Ohm/carré. L'IZO est un matériau absorbant dans la partie UV du spectre solaire mais absorbant peu dans la partie Infrarouge ce qui est favorable pour des cellules silicium dans une utilisation en tandem par exemple.

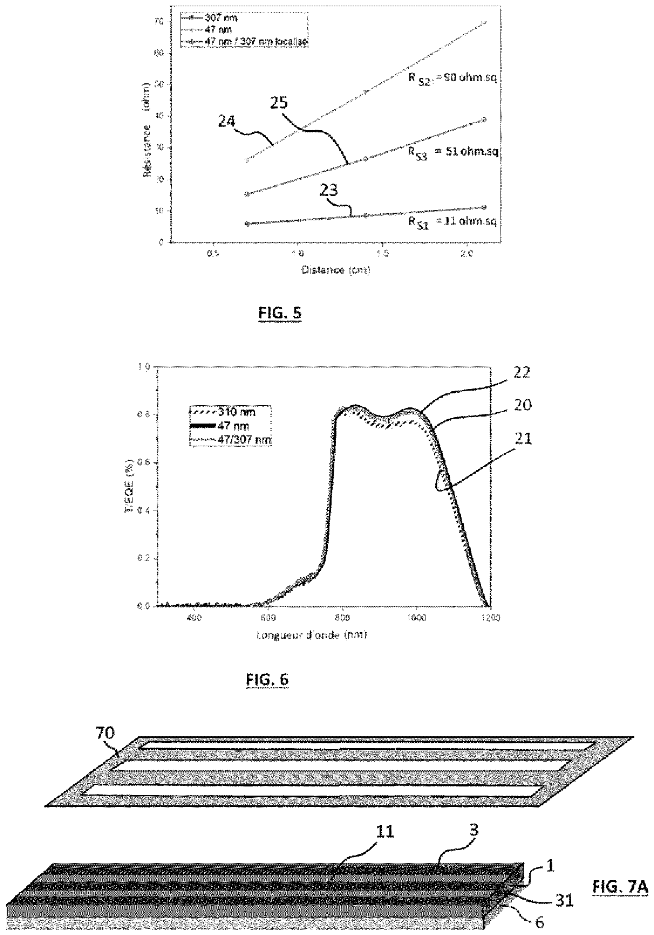

Dans un premier temps, la figure 5 montre que l'électrode réalisée avec une couche d'oxyde transparent conducteur IZO composée d'un dépôt de 47nm sur la totalité de la surface de l'électrode, associé à une surépaisseur localisée de 307nm, permet de réduire la résistance surfacique de la couche de 90 à 51 ohm/carré pour un taux de recouvrement d'environ 12% de la surface totale de la couche. Ceci permet de démontrer l'amélioration du caractère électrique de l'invention.

Ces mesures et calculs ont été réalisés avec la méthode connue sous l'appellation anglaise Transfert Length Measurements (TLM).

Les courbes obtenues donnent la résistance mesurée en fonction de la distance à un point d'origine pour une première couche 23 de 307 nm, une deuxième couche 24 de 47 nm et une troisième couche 25 à bandes alternées 47/307.

La figure 6 qui correspond à une modélisation optique de transmission et de réponse spectrale d'une cellule silicium pour différentes épaisseurs d'IZO pour les couches mesurées précédemment montre que la troisième couche d'épaisseur 47/307 nm testée permet d'avoir une courbe de transmission 20 très proche d'une couche simple de 47 nm d'épaisseur, courbe de transmission 22 tandis que la courbe de transmission 21 d'une couche de 307 nm d'épaisseur est inférieure.

Finalement, l'ensemble des données ont été combinées pour réaliser un bilan électro-optique d'une couche selon la présente divulgation pour une cellule tandem 4 terminaux avec une cellule supérieure Pérovskite à absorption dans l'UV et une cellule inférieure à base de Silicium dans le tableau ci-dessous :

**[Tableau 1]**

| | 307 nm | 47 nm | 47/307 nm |
|---|---|---|---|
| Efficacité pérovskite | 12.5% | 14% | 14.4% |
| Efficacité Silicium | 8% | 8.4% | 8.4% |
| Efficacité Tandem | 20.5% | 22.4% | 22.8% |

Dans ce tableau les valeurs sont données à 0,2% près.

Pour la cellule pérovskite, l'augmentation de 12.5 à 14% des performances de la cellule pérovskite munie d'une électrode supérieure à couche TCO IZO d'épaisseur de 47 nm par rapport à une électrode avec une couche TCO IZO de 307 nm est due à la réduction de l'épaisseur de la couche TCO IZO qui réduit l'absorption parasite dans l'UV, malgré l'augmentation de la résistivité de l'électrode. En utilisant le dispositif de bandes alternées 47 nm / 307 nm pour réaliser la couche TCO IZO, l'augmentation des performances de 14 à 14.4%, est due à la diminution de la résistivité de l'électrode, tout en gardant une transparence similaire.

Pour la cellule silicium, le gain de performances, de 8 à 8.4%, est dû à l'augmentation de la transparence de la cellule supérieure pérovskite du fait de la réduction d'épaisseur de l'électrode d'IZO vue ci-dessus. La performance de la cellule silicium reste ensuite constante car la transparence des couches transparentes conductrice reste pratiquement inchangée lors de l'ajout des bandes d'épaisseur accrue.

Pour la cellule Tandem 4T, dont les performances correspondent à l'addition des performances des cellules qui la composent, les performances obtenues sont maximales avec la configuration de couche TCO supérieure et couche TCO inférieure à bandes alternées.

L'invention est généralisable à d'autres couples épaisseur réduite / épaisseur accrue pour les couches TCO et, dans l'exemple de la figure 1, la couche d'oxyde transparent conducteur de base 1 qui réalise l'extraction de charges électriques d'une jonction photovoltaïque peut avoir une épaisseur réduite de l'ordre de 40 à 50 nanomètres et les bandes d'épaisseur accrue 2 peuvent avantageusement avoir une épaisseur de deux à dix fois supérieure à l'épaisseur de la couche de base selon le ratio gain électrique / gain transparence recherché. La largeur des bandes de résistivité inférieure peut notamment être prévue entre 10% à 20% de la surface de la couche TCO d'une électrode en fonction du compromis transparence optique / conductivité que l'on souhaite obtenir.

L'exemple de la figure 2 correspond à un deuxième mode de réalisation pour lequel des bandes de résistivité inférieure 3 sont réalisées par un surdopage localisé 31 d'une couche de base 1 d'oxyde transparent conducteur avec un dopant conducteur. Ainsi, les bandes dopées forment les bandes de résistivité inférieure et les bandes de résistivité supérieure sont réalisées par les parties moins dopée de la couche de base.

Dans ce mode de réalisation, la couche d'oxyde transparent conducteur 1 peut, comme pour le mode de réalisation de la figure 1, être une couche indium étain oxyde (ITO), indium zinc oxyde (IZO) ou peut être une couche aluminium zinc oxyde (AZO).

Dans le cas où la couche d'oxyde transparent conducteur est une couche indium étain oxyde (ITO) ou indium zinc oxyde (IZO), le dopant conducteur réalisant les bandes 3 de résistivité inférieure est à base d'étain ou de zinc dans une proportion supérieure à celle de la couche de base de dopage traditionnel réalisant les bandes de résistivité inférieure.

Dans le cas où la couche de base est une couche aluminium zinc oxyde (AZO), le dopant conducteur réalisant les bandes 3 de résistivité inférieure à la résistivité des bandes 11 est à base d'aluminium dans une proportion supérieure à celle de la couche de base.

Dans les deux cas, l'accroissement de la proportion de dopant réduira la transparence de la couche au niveau des bandes 3 de résistivité inférieure mais l'épaisseur de l'électrode pouvant être diminuée globalement, la perte en transparence est compensée par le gain en conduction de courant dans les bandes de résistivité réduites.

La figure 3 représente une succession 100 de cellules photovoltaïques 101, 102 reliées en série par des couches d'oxyde transparent conducteur inférieures 1 et supérieures 5.

Dans cet exemple, la couche d'oxyde transparent conducteur inférieure 1 est réalisée selon le deuxième mode de réalisation avec des bandes de résistivité inférieure 3 réalisées par accroissement de la proportion de dopant conducteur et des bandes de résistivité supérieure 11 de résistivité supérieure mais de plus grande transparence. Par contre, la couche d'oxyde transparent conducteur supérieure 5 est réalisée selon le premier mode de réalisation avec des bandes de résistivité réduite 7 réalisées par accroissement d'épaisseur par rapport à la couche de base formant les bandes de résistivité supérieure 53. D'autres configuration telles qu'électrode inférieure et électrode supérieure à bandes dopées ou électrode supérieure et électrode inférieure à bande d'épaisseur accrues ou encore à bandes d'épaisseur accrue et à dopage accru sont possibles dans le cadre de la présente divulgation.

Les cellules photovoltaïques en figure 3 comprennent un substrat 6 constitué d'une lame de verre sur lequel se trouve des première électrodes 1a, 1b, 1c de liaison réalisées à partir d'une couche d'oxyde transparent conducteur ici pourvue d'un surdopage localisé pour créer des bandes 3 de résistivité inférieure à la résistivité de bandes 11 de résistivité supérieure de la couche d'oxyde transparent conducteur 1.

Sur cette couche se trouvent des jonctions photovoltaïques 4a, 4b elles-mêmes surmontées par des deuxièmes électrodes de liaison 5 ici du type à bandes de résistivité inférieure 7 réalisées par accroissement d'épaisseur localisé.

Un exemple de procédé de réalisation d'un ensemble de cellules photovoltaïques mono-jonction en série est décrit aux figures 7A à 7G.

La figure 7A correspond à une étape de dépôt d'une première couche primaire d'oxyde transparent conducteur 1 sur une première lame de verre 6 par pulvérisation cathodique suivie d'une étape de surdopage localisé 31 de bandes de ladite couche primaire avec un dopant conducteur par un procédé choisi parmi la diffusion, l'implantation ionique, le dopage in situ avec un masque 70 pendant une croissance épitaxiale de ladite couche primaire, le transport vapeur-liquide-solide (VLS) pour réaliser la première couche d'oxyde transparent conducteur à bandes alternées de résistivité inférieure 3 et de résistivité supérieure 11,

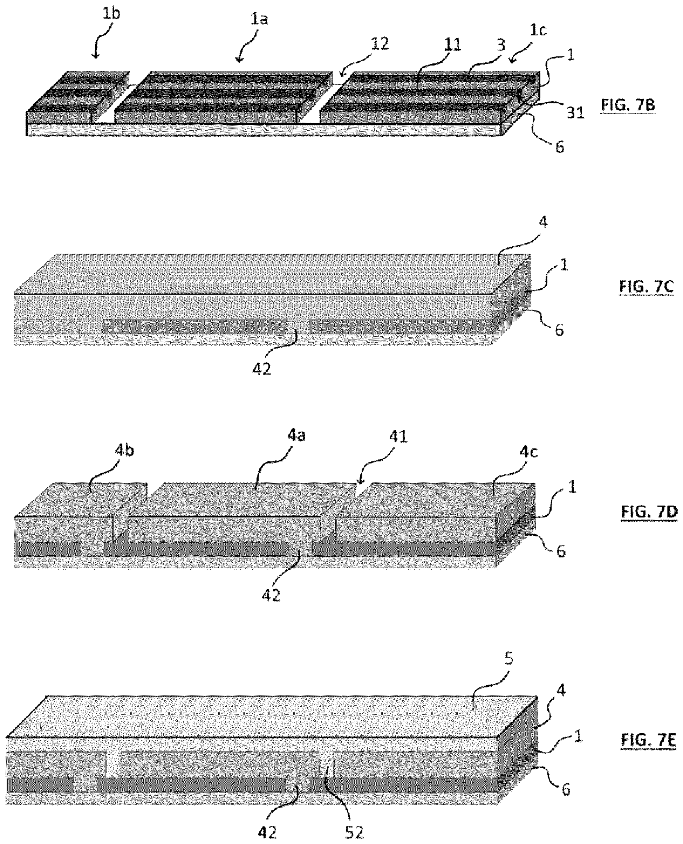

La figure 7B correspond à une étape de gravure 12 de la couche d'oxyde transparent conducteur à bandes alternées de résistivité inférieure 3 et de résistivité supérieure 11 pour former des électrodes inférieures 1a, 1b, 1c de liaison entre lesdites cellules séparées par des rainures;

La figure 7C correspond à une étape de dépôt d'un ou plusieurs matériaux 4 de de formation de jonctions photovoltaïque sur lesdites premières électrodes de liaison. Ce ou ces matériaux remplissent les rainures gravées pour réaliser des séparations 42 entre les électrodes d'oxyde transparent conducteur 1a, 1b, 1c;

La figure 7D correspond à une étape de gravure 41 desdits un ou plusieurs matériaux de formation de jonction photovoltaïque pour former des cellules 4a, 4b, 4c séparées par des rainures sur lesdites premières liaisons ;

La figure 7E correspond à une étape de dépôt d'une deuxième couche en oxyde transparent conducteur 5 sur lesdites jonctions. Ici le matériau oxyde transparent conducteur comporte des parties descendantes 52 qui s'insèrent dans les rainures entre les jonctions pour venir en contact électrique avec la couche d'oxyde transparent conducteur inférieure.

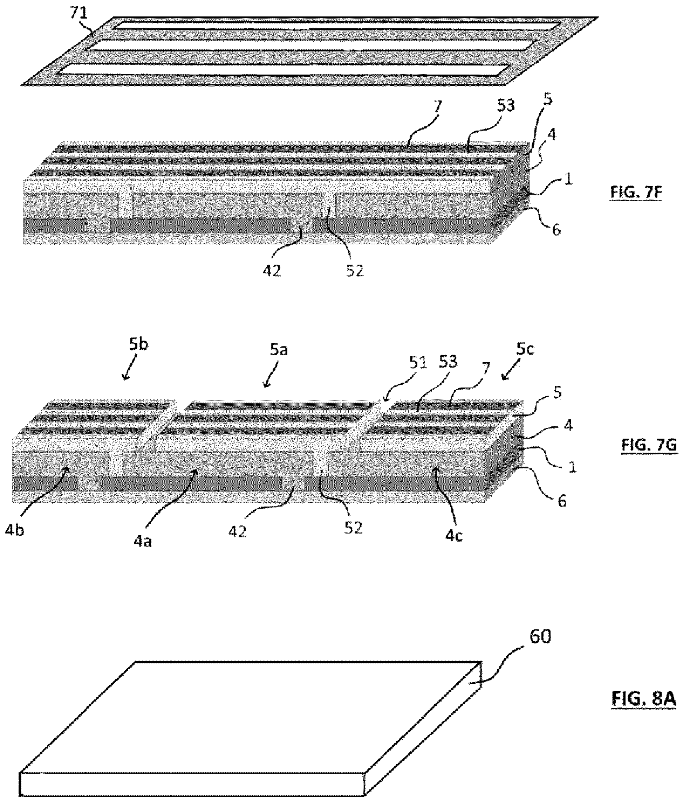

La figure 7F correspond à une étape de surdopage localisé de la deuxième couche TCO 5 pour réaliser des bandes de résistivité réduites par un procédé tel que la diffusion, l'implantation ionique, le dopage in situ avec un masque 71 pendant une croissance épitaxiale de ladite deuxième couche, le transport vapeur-liquide-solide (VLS). La deuxième couche comporte ainsi des bandes de résistivité inférieure 7 et des bandes de résistivité supérieure 53 alternées. Le surdopage est suivi en figure 7G d'une étape de gravure 51 de ladite deuxième couche pour réaliser des électrodes supérieures 5a, 5b, 5c de liaison entre cellules.

La gravure permet de séparer les électrodes et les rainures 41 permettent au matériau conducteur 52 d'une électrode supérieure en sortie d'une première cellule de venir en contact avec le matériau conducteur de l'électrode inférieure en entrée d'une cellule ultérieure.

Il est à noter qu'au niveau de l'étape de la figure 7A, le dopage peut être remplacé par un dépôt de bandes de matériau TCO pour réaliser un accroissement localisé 1' d'une épaisseur de ladite couche d'oxyde transparent conducteur par rapport à l'épaisseur des bandes de résistivité supérieure 11 tel que représenté en figure 1, les jonctions étant là aussi déposées sur la couche TCO ainsi constituée.

De même à l'étape de la figure 7F, le dopage peut être remplacé par un dépôt de bandes de matériau TCO pour réaliser un accroissement localisé 1' d'une épaisseur de ladite couche d'oxyde transparent conducteur par rapport à l'épaisseur des bandes de résistivité supérieure 11 tel que représenté aux figures 1 et 3.

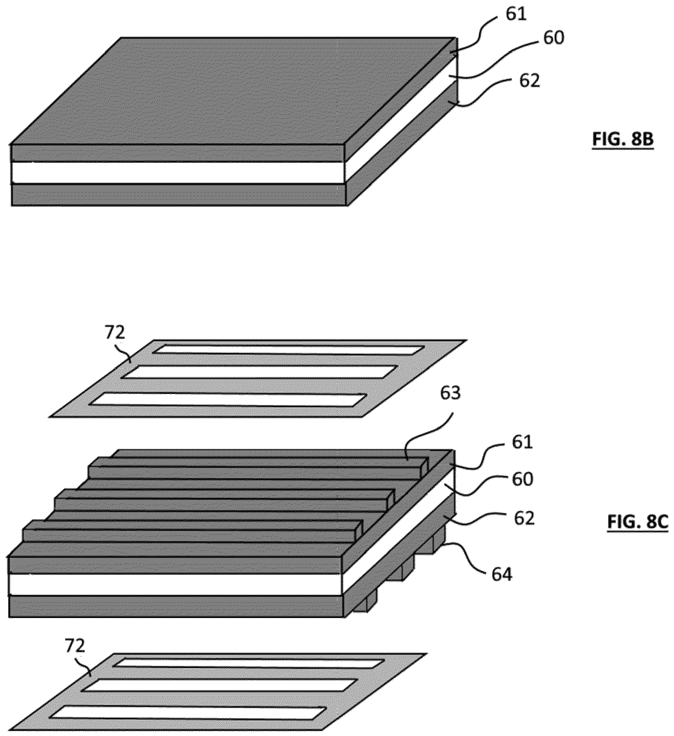

La présente divulgation peut aussi permettre la réalisation d'une cellule photovoltaïque selon un procédé comportant:
la fabrication d'une première jonction photovoltaïque 60 sans électrodes supérieure et inférieure, ceci est par exemple le cas de cellules silicium de type hétérojonction telle que représentée en figure 8A;
un dépôt d'une première couche TCO 61 sur une face supérieure de ladite cellule et d'une deuxième couche TCO 62 sur une face inférieure de ladite cellule par exemple par pulvérisation cathodique selon la figure 8B;
un dépôt TCO localisé selon la figure 8C, sous forme de premières bandes parallèles 63, 64, sur une face externe d'au moins une desdites première couche TCO 61 et deuxième couche TCO 62 par pulvérisation cathodique, en utilisant un masque 72.

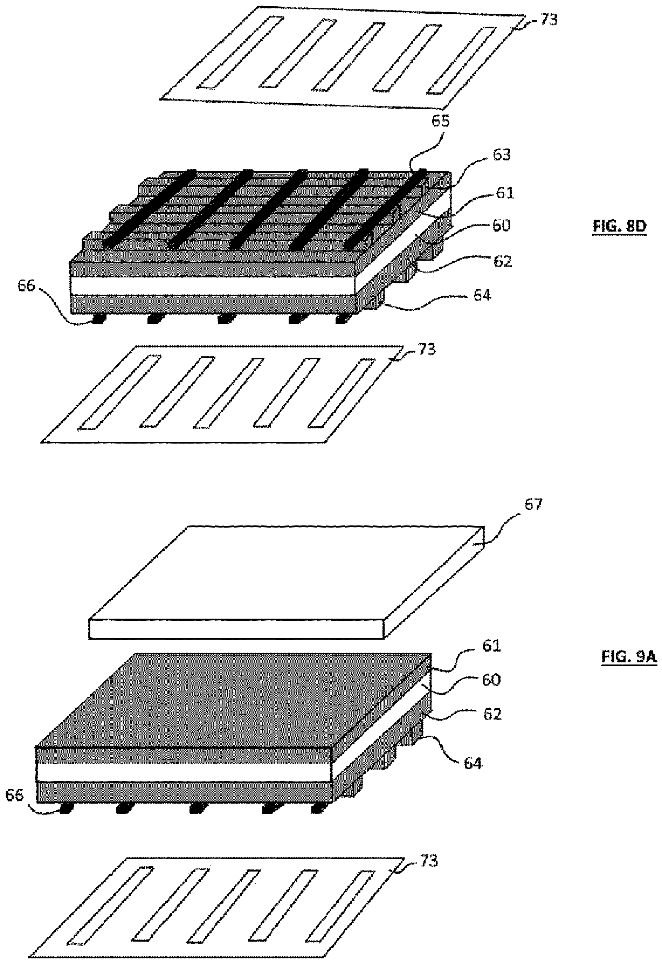

Selon la figure 8D, les couches TCO peuvent recevoir un dépôt d'une première grille métallique 65 par pulvérisation cathodique, perpendiculairement auxdites bandes TCO 63 sur la face externe de la première couche TCO 61 au travers d'un premier masque 73 et éventuellement un dépôt d'une deuxième grille métallique 66 par pulvérisation cathodique, perpendiculairement auxdites bandes TCO 64 sur la face externe de la deuxième couche TCO 62 au travers d'un deuxième masque 73. Une telle grille métallique est par ailleurs représentée en figure 4 déposées sur les bandes TCO 7 et perpendiculairement à ces dernières qui dépassent de la couche de base formant les bandes de résistivité supérieure 11.

Dans le cas d'une cellule tandem, le dépôt peut comporter à partir de l'empilage de la figure 8B, un dépôt de bandes 64 uniquement sur la face inférieure de la couche TCO Inférieure 62 par pulvérisation cathodique et un dépôt d'une grille métallique par pulvérisation cathodique, perpendiculairement auxdites bandes TCO sur la face inférieure de la couche TCO inférieure. Selon la figure 9A est alors réalisé le dépôt d'une deuxième jonction photovoltaïque 67 sur une face avant formée par la couche TCO supérieure 61.

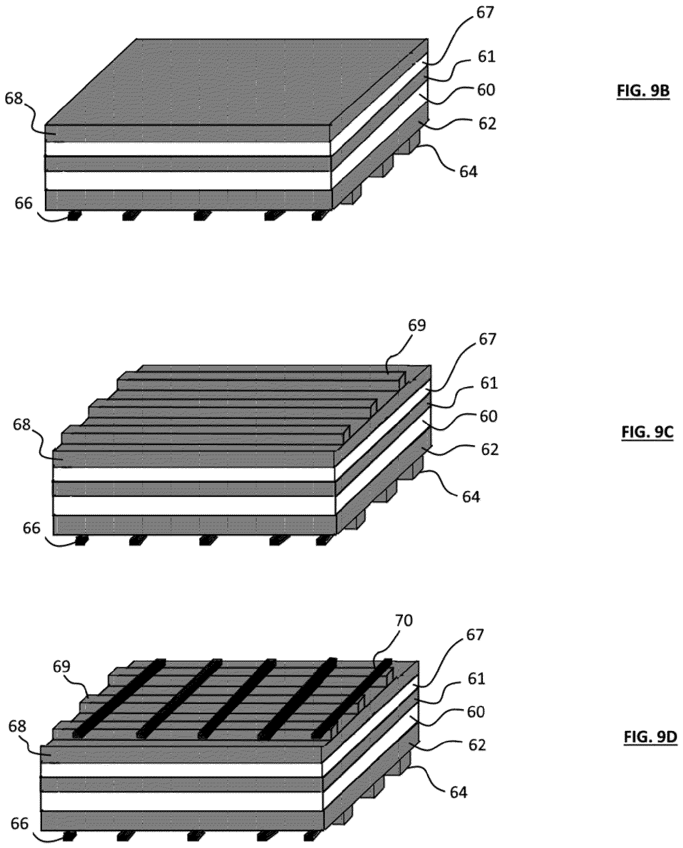

La fabrication de la cellule tandem peut alors se poursuivre par un dépôt d'une troisième couche TCO 67 par pulvérisation cathodique sur une face supérieure de ladite deuxième jonction photovoltaïque comme en figure 9B.

Ensuite sont réalisés un dépôt localisé de bandes parallèles TCO d'épaisseur accrue 69 sur ladite troisième couche comme en figure 9C et un dépôt d'une deuxième grille métallique par pulvérisation cathodique, perpendiculaire aux bandes TCO d'épaisseur accrue sur ladite troisième couche comme en figure 9D.

L'invention peut ainsi permettre les améliorations suivantes, applicables sur des cellules solaires mono ou multi-jonctions :
a. - Suppression d'au moins une grille métallique dans le cas de cellules de type Pérovskite pour résoudre le problème de compatibilité du procédé de fabrication de certaines cellules solaires avec l'étape de fabrication de la grille métallique par pulvérisation cathodique (sputtering en anglais). En effet, par exemple dans le cas de la fabrication de cellules Pérovskite, les couches HTL, ETL et Pérovskite sont particulièrement sensibles à la température. Le procédé de métallisation par pulvérisation utilise des températures de dépôts supérieures à 150°C, ce qui le rend incompatible si cette étape intervient après la fabrication du reste de la cellule.
b. - Diminution des besoins de métallisation pourrait permettre la réalisation de cellules silicium avec un nombre de barres de connexion (busbars en anglais) réduit voire des cellules sans barres de connexion (busbars), ce qui permet de réduire l'ombrage, soit sur une seule face soit en face avant et face arrière dans le cadre de cellules bifaciales et peut réduire les coûts de métallisation. L'invention est notamment compatible avec l'utilisation de la technologie de connexion par grille métallique (connu sous la terminologie anglo-saxonne Smartwire Connection Technology SWTC^{™}) pour interconnecter des cellules entre elles.

La présente divulgation peut également permettre, grâce à une diminution de la résistance surfacique, d'élargir la zone active dans le cadre de gravures de type P1 P2 P3, couramment utilisé dans la fabrication de modules en couches minces, par exemple CIGS, CdTe ou à base de Pérovskite par exemple, réduisant ainsi la proportion de zone inactive dans le module.

Toutefois, l'augmentation locale du taux de dopage ou d'épaisseur du TCO peut créer une absorption parasite plus importante par cette couche dans une partie du spectre solaire, ce qui diminuera le courant pouvant être généré par la cellule solaire. Par une optimisation du ratio des dimensions et conductivité des bandes de résistivité inférieure mais de transparence optique réduite par rapport aux bandes de résistivité supérieure mais de transparence optique supérieure, une augmentation globale de la performance des cellules solaires peut être obtenue.

L'énergie de gap des cellules solaires, la nature des matériaux utilisés et la structure générale (simple ou multi-jonction) auront aussi une influence sur l'optimisation et l'efficacité de l'invention.

L'invention n'est pas limitée aux exemples représentés et notamment les bandes d'épaisseur accrue peuvent être réalisées avec un matériau plus fortement dopé pour combiner les deux méthodes d'accroissement de conductivité.

## Revendications

1. - Cellule photovoltaïque (101, 102) comportant au moins une jonction semiconductrice (4) de conversion photo-électrique recouverte sur au moins une de ses faces par au moins une couche transparente conductrice (1, 5) d'extraction de charges électriques de la jonction, **caractérisée en ce que** ladite couche transparente conductrice comporte une alternance de bandes de résistivité supérieure à un premier seuil, dites bandes de résistivité supérieure (11, 11, 53) , et de bandes de résistivité inférieure à un deuxième seuil, dites bandes de résistivité inférieure (2, 3, 7) adaptées pour faciliter un transports desdites charges électriques, **caractérisée en ce que** ladite couche transparente conductrice est une couche d'oxyde transparent conducteur, ledit oxyde transparent conducteur est un oxyde d'indium dopé étain (ITO), un oxyde d'indium dopé zinc (IZO) ou un oxyde d'aluminium dopé zinc (AZO) et **caractérisée en ce que** lesdites bandes de résistivité inférieure (3) comportent un surdopage localisé (31) de ladite couche d'oxyde transparent conducteur (1) avec un dopant conducteur par rapport aux bandes de résistivité supérieure (11) sans accroissement d'épaisseur desdites bandes de résistivité inférieure.

2. - Cellule photovoltaïque selon la revendication 1, pour laquelle ledit deuxième seuil est inférieur ou égal audit premier seuil.

3. - Cellule photovoltaïque selon l'une quelconque des revendications précédentes, pour laquelle lesdites bandes de résistivité inférieure (2, 3) occupent une surface de 5 à 20% de la surface totale de ladite couche transparente conductrice.

4. - Cellule photovoltaïque selon l'une quelconque des revendications précédentes, pour laquelle lesdites bandes de résistivité inférieure sont orientées dans une direction de transport du courant de ladite cellule vers une cellule adjacente.

5. - Procédé de réalisation d'un module photovoltaïque à une ou plusieurs cellules selon l'une quelconque des revendications précédentes, **caractérisé en ce qu'**il comporte :
a. le dépôt d'une première couche primaire (1) de matériau transparent conducteur sur un substrat (6) tel qu'une lame de verre par pulvérisation cathodique et un surdopage localisé de bandes de ladite première couche primaire avec un dopant conducteur par un procédé choisi parmi la diffusion, l'implantation ionique, le dopage in situ avec masque (71) pendant une croissance épitaxiale de ladite première couche primaire, le transport vapeur-liquide-solide (VLS) pour réaliser une première couche transparente conductrice à bandes alternées de résistivité inférieure et de résistivité supérieure, sans accroissement d'épaisseur desdites bandes de résistivité inférieure ;
b. une gravure de ladite première couche transparente conductrice à bandes alternées de résistivité inférieure et de résistivité supérieure pour former des premières électrodes de liaison entre lesdites cellules ;
c. un dépôt d'une ou plusieurs couches de jonction photovoltaïque sur lesdites premières électrodes de liaison ;
d. une gravure de ladite une ou plusieurs couches de jonction photovoltaïque pour former les jonctions desdites cellules sur lesdites premières électrodes ;
e. le dépôt d'au moins une deuxième couche primaire transparente conductrice ou d'une couche en matériau conducteur opaque sur lesdites jonctions et une gravure de ladite deuxième couche pour réaliser des deuxièmes électrodes de liaison entre cellules.

6. - Procédé selon la revendication 5, comportant, avant la gravure de ladite deuxième couche primaire, un surdopage localisé de bandes de la deuxième couche primaire par un procédé choisi parmi la diffusion, l'implantation ionique, le dopage in situ avec masque pendant une croissance épitaxiale de ladite deuxième couche primaire, le transport vapeur-liquide-solide (VLS) pour réaliser des bandes alternées de résistivité inférieure et de résistivité supérieure sans accroissement d'épaisseur desdites bandes de résistivité inférieure.

7. - Procédé de réalisation d'une cellule photovoltaïque selon l'une quelconque des revendications 1 à 4, comportant:
a. la fabrication d'une première jonction photovoltaïque (60) sans électrodes supérieure et inférieure ;
b. un dépôt par pulvérisation cathodique d'au moins une couche transparente conductrice supérieure (61) sur une face supérieure de ladite cellule et d'au moins une couche transparente conductrice inférieure (62) sur une face inférieure de ladite cellule ;
c. un surdopage localisé de premières bandes parallèles transparentes conductrices (63, 64) sans accroissement d'épaisseur, sur une face externe d'au moins une desdites couche transparente conductrice inférieure et couche transparente conductrice supérieure par pulvérisation cathodique, en utilisant un masque (72).

8. - Procédé selon la revendication 7 comportant un dépôt d'une grille métallique (65, 66) par pulvérisation cathodique au travers d'un masque (73), perpendiculairement auxdites bandes parallèles transparentes conductrices sur au moins ladite face externe d'au moins une desdites couche transparente conductrice supérieure (61) et couche transparente conductrice inférieure (62).

9. - Procédé selon la revendication 7 ou 8 pour la réalisation d'une cellule photovoltaïque tandem comportant :
a. un dépôt d'une deuxième jonction photovoltaïque (67) sur une face avant formée par la première couche transparente conductrice (61) ;
b. un dépôt d'une troisième couche transparente conductrice (68) par pulvérisation cathodique sur une face libre de ladite deuxième jonction photovoltaïque ;
c. un surdopage localisé de deuxièmes bandes parallèles transparentes conductrices (69) sans accroissement localisé sur ladite troisième couche ;
d. un dépôt d'une deuxième grille métallique (70) par pulvérisation cathodique, perpendiculaire aux bandes transparentes conductrices d'épaisseur accrue sur ladite troisième couche.

10. - Procédé selon l'une quelconque des revendications 5 à 9 pour lequel les couches transparentes conductrices sont des couches d'oxyde transparent conducteur.
